# FASCICULE DE BREVET EUROPEEN

(11) **EP 2 864 148 B1**
(45) Date de publication et mention de la délivrance du brevet: **17.08.2016**
(21) Numéro de dépôt: 13733358.9
(22) Date de dépôt: 06.06.2013
(51) Int. Cl.: B60L 3/12, G01R 27/20

(54) **DISPOSITIF DE MESURE DE RESISTANCE DE PRISE DE TERRE ET CHARGEUR POUR VEHICULE EMBARQUE MUNI D'UN TEL DISPOSITIF**
VORRICHTUNG ZUR MESSUNG DES WIDERSTANDS IN EINEM MASSEANSCHLUSS UND FAHRZEUGINTERNES LADEGERÄT MIT SOLCH EINER VORRICHTUNG
DEVICE FOR MEASURING RESISTANCE OF EARTH TAP AND CHARGER FOR ON-BOARD VEHICLE FURNISHED WITH SUCH A DEVICE

(30) Priorité: 20.06.2012 FR 1255793; 22.06.2012 US 201261663013 P
(43) Date de publication de la demande: 29.04.2015
(73) Titulaire: Renault S.A.S., 92100 Boulogne-Billancourt (FR)
(72) Inventeur: RIPOLL, Christophe, F-78460 Chevreuse (FR); KONATE, Christophe, F-91300 Massy (FR); CUILLER, Etienne, F-78310 Maurepas (FR)
(86) Numéro de dépôt international: PCT/FR2013/051293
(87) Numéro de publication internationale: WO 2013/190207

(56) Documents cités:
- GE-B- P20 125 544
- JP-A- 2009 207 286
- JP-A- 2010 205 569

## Description

L'invention a pour objet les dispositifs de mesure de résistance de prise de terre, et en particulier les dispositifs de mesure de résistance de prise de terre intégrés à un chargeur de batterie embarqué sur un véhicule.

Les intensités de courant utilisées lors de la recharge de batterie destinée à la propulsion d'un véhicule électrique, sont particulièrement élevées.

Pour des raisons de sécurité, il est donc nécessaire, avant de commencer à recharger la batterie, de vérifier, que la mise à la terre du chargeur est suffisamment efficace, afin de protéger en cas de fuite de courant, des personnes qui viendraient en contact avec le véhicule.

Des dispositifs de mesure de résistance de prise de terre existent. Ils comprennent typiquement une première branche électrique équipée d'un générateur de courant et d'un ampèremètre, et que l'on connecte sur une phase du réseau électrique. Ils comprennent en outre une seconde branche sur laquelle sont placées une capacité et une résistance, équipée d'un voltmètre, branche que l'on connecte sur un fil de neutre du réseau électrique.

La mesure de résistance de terre doit normalement se faire sans appareil électrique branché sur le réseau, autre que le dispositif de mesure de prise de terre. Si un autre appareil est branché sur le réseau, il peut créer des boucles de courant perturbatrices qui risquent de modifier le résultat de la mesure.

Le document JP 2009207286 décrit une borne de dérivation d'un fil terre et un panneau de distribution pour mesurer la résistance de prise de terre.

L'invention a pour but de proposer un dispositif de mesure de prise de terre qui permet de garder une bonne précision de mesure tout en ayant une sensibilité réduite aux courants perturbateurs engendrés par d'éventuels appareils branchés sur le réseau d'alimentation utilisé.

A cette fin, l'invention propose un dispositif de mesure d'une résistance de terre d'une installation, comprenant :
- une source de courant et un ampèremètre disposés sur une première branche, prévue pour relier une phase d'un réseau d'alimentation avec la terre de l'installation,
- une seconde branche prévue pour relier un fil de neutre du réseau d'alimentation avec la terre de l'installation, comportant une résistance aux bornes de laquelle est branché un voltmètre, et comportant une première capacité en série avec la résistance.

Le dispositif comporte une troisième branche prévue pour relier le fil de neutre du réseau avec la terre de l'installation, et comporte, en parallèle à la première capacité et à la première résistance, une seconde capacité de valeur supérieure à la première capacité.

Une inductance peut être placée en série avec la résistance et avec la première capacité, parallèlement à la seconde capacité.

Avantageusement, la seconde capacité est au moins cinq fois supérieure à la première capacité, et de préférence au moins dix fois supérieure à la première capacité.

La seconde capacité peut avoir une valeur comprise entre 10 et 100 nF (nanofarad), et de préférence comprise entre 20 et 300 nF.

L'inductance peut avoir une valeur comprise entre 1 et 10 mH (millihenry).

L'invention propose également un chargeur pour batterie de véhicule automobile, comprenant le dispositif de mesure de prise de terre décrit.

Le chargeur peut comprendre un relais apte à connecter la seconde branche alternativement à une première borne de connexion d'alimentation du chargeur, et à une seconde borne de connexion d'alimentation du chargeur, distincte de la première borne. Le chargeur peut également comprendre un second voltmètre (15) branché entre la borne de prise de terre, et la seconde borne, de manière à pouvoir être déconnecté par le relai, et comprendre un troisième voltmètre branché entre la borne de prise de terre, et la première borne de manière à pouvoir être déconnecté par le relai.

Selon un mode de réalisation préféré, la première branche et la seconde branche peuvent être connectées respectivement à une première borne d'entrée du dispositif et à une seconde borne d'entrée du dispositif, ou être connectées au contraire respectivement à la seconde et à la première borne, à l'aide d'un même interrupteur mécanique comportant des connexions dédoublées soit du côté des bornes de connexion, soit aux extrémités de la première et de la seconde branche électrique, et comportant deux contacteurs aptes à basculer chacun, simultanément, l'un de la première à la seconde, et l'autre de la seconde à la première des extrémités dédoublées.

Le chargeur peut comprendre une unité de commande électronique configurée, lors du branchement des bornes sur un réseau d'alimentation, pour faire basculer le relai de manière à ce que la seconde branche soit connectée à celle des deux bornes pour laquelle la tension aux bornes de la seconde capacité est la plus faible.

L'unité de commande électronique peut être configurée pour interdire le rechargement d'une batterie suite à une tentative de connexion à un réseau d'alimentation, si la tension mesurée aux bornes de la résistance reste supérieure à une tension seuil après l'actionnement du relais.

L'unité de commande électronique peut être configurée pour interdire le rechargement d'une batterie si une résistance de terre calculée à partir des indications de l'ampèremètre et du premier voltmètre est supérieure ou égale à une résistance seuil.

D'autres buts, caractéristiques et avantages de l'invention apparaîtront à la lecture de la description suivante, donnée uniquement à titre d'exemple non limitatif, et faite en référence aux dessins annexés sur lesquels :
- la figure 1 est une représentation schématique d'un dispositif de mesure de prise de terre selon l'art antérieur,
- la figure 2 est une représentation schématique d'un dispositif de mesure de prise de terre selon l'invention, et
- la figure 3 est une représentation schématique d'un autre dispositif de mesure de prise de terre selon l'invention.

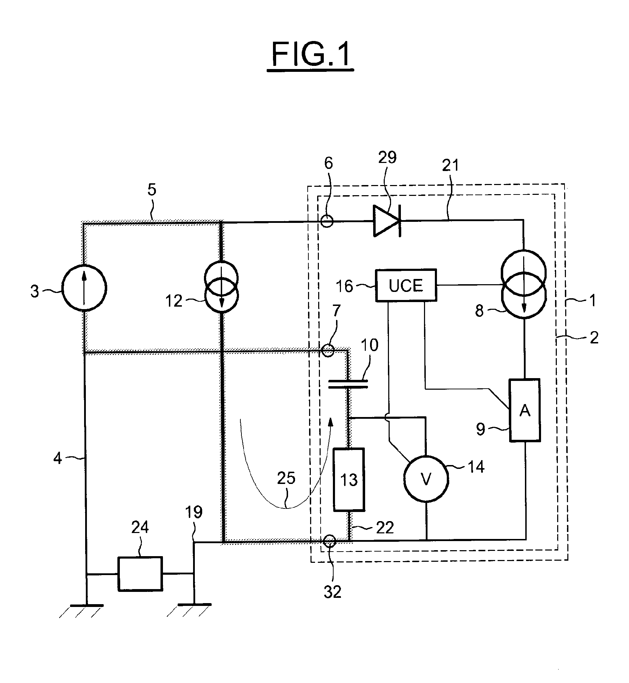

Tel qu'illustré sur la figure 1, un chargeur de batterie 1 embarqué sur un véhicule comprend un dispositif de mesure de résistance de terre 2. Le chargeur 1 comprend une première borne de branchement 6 et une seconde borne de branchement 7 qui sont géométriquement configurées pour pouvoir être insérées, la première dans une fiche de prise de courant reliée à un fil de phase 5 d'un réseau électrique 3, la seconde dans une fiche connectée à un fil de neutre 4 du même réseau électrique.

Le réseau électrique est ici schématiquement symbolisé par une source de tension 3.

Le chargeur 1 comprend également une borne de terre 32 configurée de manière à pouvoir être mise en contact électrique avec un fil de terre 19 du réseau électrique.

Le dispositif de mesure 2 comprend une première branche électrique 21 reliant la première borne 6 et la borne de prise de terre 32. Sur cette branche 21 est disposé un générateur de courant 8 monté en série avec un ampèremètre 9 et avec une diode 29 configurée pour laisser passer le courant électrique du réseau uniquement dans le même sens que le courant injecté par le générateur de courant 8.

Le dispositif de mesure de résistance de terre 2 comprend en outre une seconde branche électrique 22 reliant la seconde borne de branchement 7 avec la borne de prise de terre 32. Sur cette seconde branche, sont disposées en série une première capacité 10 et une résistance 13, aux bornes de laquelle est branché un premier voltmètre 14. Une unité de commande électronique 16 est reliée au voltmètre 14 et à l'ampèremètre 9 afin de pouvoir collecter les valeurs mesurées par le voltmètre et par l'ampèremètre. L'unité de commande électronique 16 est également reliée au générateur de courant 8 de manière à pouvoir piloter une injection de courant dans la première branche 21 du dispositif de mesure 2.

L'injection de courant par le générateur 8 dans la seconde branche provoque un retour de courant par la prise de terre 32 vers le neutre 4 du réseau électrique 3, ainsi qu'une boucle de courant parallèle passant par la résistance 13.

Une résistance électrique 24 peut être mesurée comme s'opposant au passage du courant entre la prise de terre 19 et le neutre 4 du réseau. Cette résistance 24 correspond à la résistance de terre que l'on souhaite mesurer à l'aide du dispositif 2.

Des procédures de mesure connues permettent à l'unité de commande électronique 16, à partir des valeurs délivrées par l'ampèremètre 9 et le voltmètre 14, de déduire la valeur de la résistance de terre 24. Par exemple, on peut considérer en première approximation que la résistance 24 de prise de terre a pour valeur R_{T}, avec :
R_{T} = V/A, où V est une tension mesurée par le premier voltmètre 14, et A est l'intensité du courant mesurée dans le même temps par l'ampèremètre 9, notamment si la valeur R_{T} ainsi déterminée est sensiblement inférieure à la valeur de la résistance 13.

Cependant, si la mesure est effectuée alors qu'un appareil électrique perturbateur 12 est connecté sur le même réseau électrique 3, cet appareil perturbateur 12 peut envoyer un courant parasite vers la prise de terre 19 et engendrer une boucle de courant parasite 25 -représentée sur la figure 1 à l'aide d'un trait en surépaisseur et d'une flèche indiquant le passage du courant-. Cette boucle de courant parasite 25 transite par la résistance 13 et vient alors modifier les résultats de mesure de résistance de terre effectuées par l'unité de commande électronique 16.

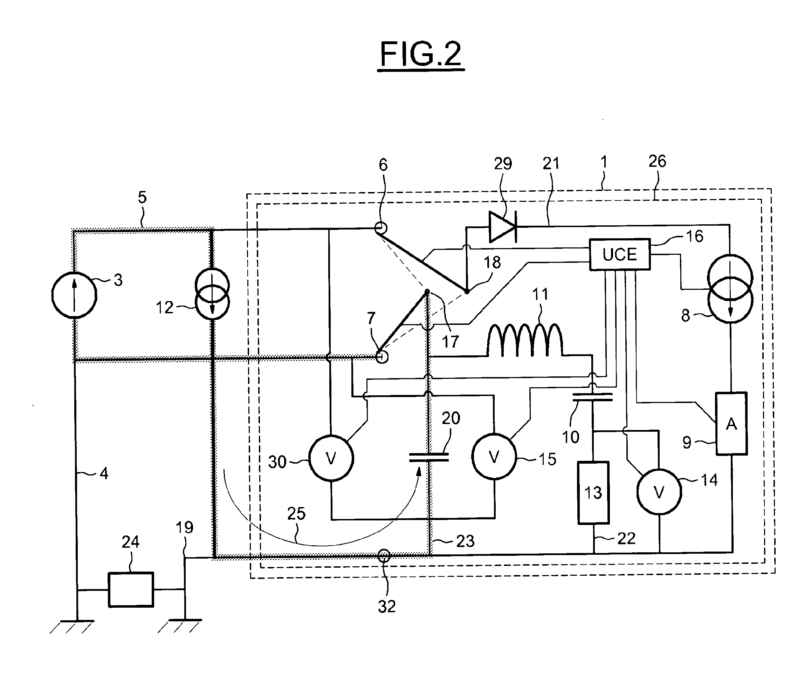

La figure 2 illustre un chargeur 1 équipé d'un dispositif de mesure de résistance 26 selon l'invention.

On retrouve sur la figure 2 des éléments communs au dispositif de mesure de prise de terre 2 de la figure 1, les mêmes éléments étant désignés par les mêmes références.

Le dispositif de mesure 26 comporte une troisième branche 23 reliant la seconde borne 7 et la borne de prise de terre 32.

Sur cette branche, est placée une capacité 20 de valeur supérieure à la capacité 10. Un second voltmètre 15 peut être branché entre la borne de prise de terre 32 et la première borne 6 de branchement du chargeur. Un troisième voltmètre 30 peut être branché entre la borne de prise de terre 32 et la seconde borne 7 de branchement du chargeur.

La seconde branche 22 peut rester identique à celle décrite pour le dispositif 2 de la figure 1, ou peut comporter une inductance 11 placée en série avec la première capacité 10.

La valeur de la capacité 20 est choisie de manière à être sensiblement supérieure, par exemple dix fois supérieure, à la capacité 10 de la seconde branche. De cette manière, les courants parasites engendrés par le perturbateur 12, qui sont généralement de fréquence plus élevée que les fréquences utilisées pour la mesure de résistance de prise de terre, et qui sont généralement de fréquence plus élevée que la fréquence du réseau électrique, "voient" une impédance plus faible au niveau de la capacité 20, que ne n'est l'impédance de la seconde branche. Cette différence d'impédance dévie la boucle de courant parasite 25 vers la troisième branche et évite que ces courants parasites ne viennent perturber les courants de mesure transitant par la seconde branche du dispositif 26.

Les courants perturbateurs engendrés par des appareils domestiques peuvent typiquement avoir une fréquence de l'ordre du kilohertz, à comparer aux 50 Hertz délivrés par le réseau électrique. L'inductance 11 permet elle, d'augmenter l'impédance « vue » par les courants parasites sur la seconde branche 22 du dispositif 26.

Pour de telles fréquences de courants, on peut avantageusement choisir une capacité ayant une valeur comprise entre 10 et 100 nF (nanofarad), et de préférence comprise entre 20 et 300 nF.

L'inductance peut avoir une valeur comprise entre 1 et 10 mH (millihenry). Elle peut être nulle dans la variante de réalisation sans inductance supplémentaire.

La procédure de mesure de résistance de terre telle qu'effectuée par l'unité de commande électronique 16 reste dans l'essentiel inchangée.

Le dispositif de mesure de prise de terre 26 peut en outre comporter un système de relais au niveau des bornes de connexion 6 et 7, afin d'assurer que la première branche soit bien connectée à un fil de phase 5 du réseau et que la seconde branche 22 soit bien connectée au fil de neutre 4 du réseau 3.

Un premier relais 17 peut par exemple être apte à basculer la connexion de la seconde branche 22 alternativement vers la première borne physique 6 et vers la seconde borne physique 7.

Un second relais 18 peut être apte à basculer la connexion de la première branche 21 alternativement vers la première borne physique 6 et vers la seconde borne physique 7.

Les mesures effectuées par les voltmètres 15 et 30 permettent de vérifier l'emplacement du neutre 4, puis de connecter, après avoir effectué ces mesures, la seconde branche 22 et la troisième branche 23 au neutre 4, et de connecter la première branche 21 à la phase 5.

On assure ainsi que la seconde branche 22 est bien connectée au fil de neutre 4 du réseau 3. L'unité de commande électronique 16 peut alors basculer le second relais 18, d'une position où il n'est en contact avec ni la borne 7 ni la borne 6, de manière à le mettre en contact avec la borne laissée disponible par le premier relais 17.

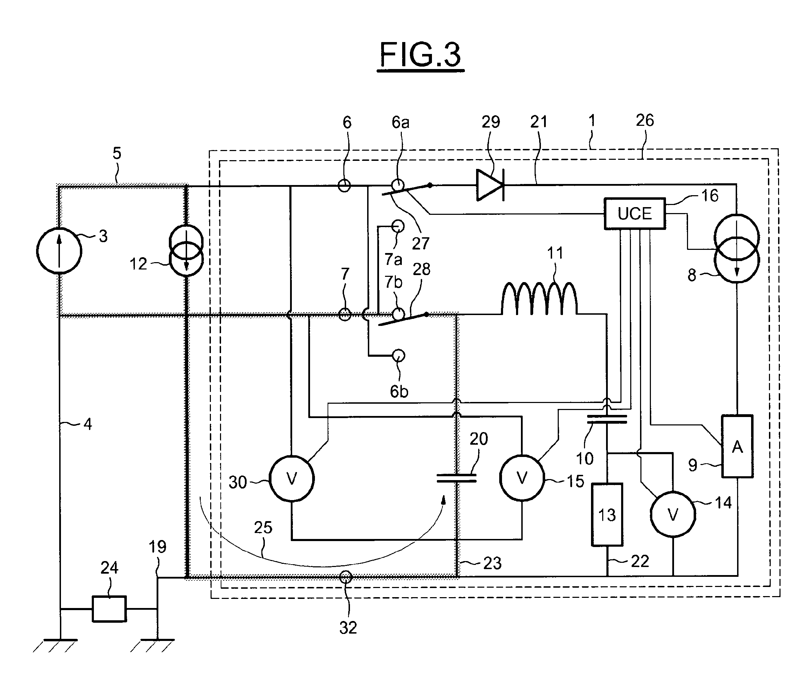

La figure 3 illustre une variante de réalisation du chargeur de la figure 2. Dans cette variante de réalisation, les connexions au réseau de la première et de la seconde branches se font à l'aide d'un double interrupteur comprenant un premier contacteur 27 et un second contacteur 28 actionnés simultanément par l'unité de commande électronique 16. La borne 6 et la borne 7 du chargeur 1 sont chacune dédoublées, respectivement en deux points de contact 6a, 6b de la borne 6 et en deux points de contact 7a, 7b de la borne 7. Les points de contact 6a, 6b se trouvent par exemple à l'extérieur des points de contact 7a, 7b. Le premier contacteur 27 relié à la première branche 21 est apte à basculer du contact 6a vers le contact 7a et le second contacteur est apte à basculer simultanément du contact 7b vers le contact 6b.

Lorsque le premier contacteur 27 est en contact avec le contact 6a, le second contacteur 28 est en contact avec le contact 7b. On considère alors que la borne 6 est branchée à une phase du réseau comme illustré en figure 1, et la borne 7 est branchée sur le fil neutre 4 du réseau.

Lorsque la borne 6 se retrouve branchée sur le fil neutre du réseau et la borne 7 sur une phase du réseau (configuration non représentée sur les figures), l'unité de commande électronique 16 bascule le contacteur 27 de manière à ce qu'il vienne en contact avec le contact 7a. Le contacteur 28 bascule alors simultanément avec le contact 6b, par exemple du fait d'un lien mécanique reliant les deux contacteurs. La première branche 21 se retrouve ainsi connectée à la phase 5 et la seconde branche 22 connectée au neutre 4.

Selon une variante de réalisation, les connexions peuvent être dédoublées du côté de la première 21 et de la seconde 22 branches électriques, au lieu d'être dédoublées au niveau des bornes de connexion 6 et 7. De manière similaire au mode de réalisation de la figure 2, deux voltmètre 15 et 30 placés en amont des contacteurs permettent à l'unité de commande électronique 16 de brancher la première branche 21 sur la phase 5 du réseau, et de brancher la seconde branche 22 sur le neutre 4 du réseau.

L'unité de commande électronique 16 peut être configurée pour interdire l'utilisation du chargeur, si après avoir tenté de connecter correctement la première et la seconde branches respectivement à la phase et au neutre du réseau, la tension mesurée par le voltmètre 14 reste supérieure à un seuil choisi d'avance. Cette tension anormale peut par exemple être due à une défaillance du système de contacteurs 17-18 ou 27-28, qui reste bloqué dans la configuration inverse de celle souhaitée par rapport à la configuration géométrique de la prise électrique utilisée pour brancher le chargeur 14 au réseau 3.

L'unité de commande électronique 16 peut également être configurée pour interdire l'utilisation du chargeur si la résistance de prise de terre est supérieure à un seuil déterminé, par exemple supérieur à une centaine d'Ohms, ou à défaut pour une résistance de terre supérieure à 200Ohms.

Le dispositif de mesure de résistance de prise de terre selon l'invention permet à la fois d'améliorer la sécurité, en surveillant de manière fiable la valeur de résistance de mise à la terre de l'installation, et permet également de veiller au branchement correct du dispositif, afin d'éviter, si les fils de phase et le neutre de l'installation sont permutés, de brancher le fil de phase directement sur la troisième branche du dispositif, ce qui risquerait d'envoyer des intensités de courant non souhaitées vers la masse du véhicule.

L'invention ne se résume pas aux exemples de réalisation décrits et peut se décliner en de nombreuses variantes.

Le dispositif de mesure de prise de terre 26 peut être dépourvu de connexions à géométrie variable permettant de permuter la phase et le neutre.

Le dispositif peut être conçu pour être branché sur un réseau monophasé, biphasé ou triphasé, à condition que l'installation comporte au moins un fil de phase, un fil de neutre et un fil correspondant à la mise à la terre.

Le branchement du dispositif peut alors se faire entre un des fils de phase et le fil de neutre.

Le dispositif peut ne pas comporter d'inductance 11, ou ne pas comporter de second voltmètre 15 ni de troisième voltmètre 30. Les valeurs retenues pour la première et pour la seconde capacités peuvent être modifiées en fonction des gammes de fréquence de courant du réseau et des gammes de fréquence de courant des perturbateurs attendus sur ce réseau. Les fréquences d'injection de courant utilisées au niveau du générateur de courant 8 peuvent être adaptées, pour éloigner ces fréquences des fréquences attendues pour les courants parasites émis par les perturbateurs 12. Si le perturbateur 12 attendu fonctionne au contraire dans un domaine de fréquence sensiblement inférieur aux fréquences utilisées au niveau du générateur de courant 8, on peut remplacer la capacité 20 au niveau de la troisième branche par une inductance de faible valeur, par exemple de valeur comprise entre 1 et 10 mH.

D'autres résistances, capacités, inductances supplémentaires peuvent être prévues dans le dispositif, en plus des composants déjà mentionnés.

## Revendications

1. Dispositif (26) de mesure d'une résistance (24) de terre d'une installation, comprenant :
- une source de courant (8) et un ampèremètre (9) disposés sur une première branche (21) électrique, prévue pour relier une phase (5) d'un réseau d'alimentation (3) avec la terre (19) de l'installation,
- une seconde branche (22) électrique prévue pour relier un fil de neutre (4) du réseau d'alimentation (3) avec la terre (19) de l'installation, comportant une résistance (13) aux bornes de laquelle est branché un voltmètre (14), et comportant une première capacité (10) en série avec la résistance,
**caractérisé en ce que** le dispositif comporte une troisième branche électrique (23) prévue pour relier le fil de neutre (4) du réseau avec la terre (19) de l'installation, et comporte sur la troisième branche (23), en parallèle à la première capacité (10) et à la première résistance (13), une seconde capacité (20) de valeur supérieure à la première capacité (10).

2. Dispositif selon la revendication 1, dans lequel une inductance (11) est placée en série avec la résistance (13) et avec la première capacité (10), parallèlement à la seconde capacité (20).

3. Dispositif selon la revendication 1, dans lequel la seconde capacité (20) est au moins cinq fois supérieure à la première capacité (10), et de préférence au moins dix fois supérieure à la première capacité.

4. Dispositif selon l'une quelconque des revendications précédentes, dans lequel la seconde capacité (20) a une valeur comprise entre 10 et 100 nF, et de préférence comprise entre 20 et 300 nF.

5. Dispositif selon l'une quelconque des revendications 2 à 4, dans lequel l'inductance (11) a une valeur comprise entre 1 et 10 mH.

6. Chargeur (1) pour batterie de véhicule automobile, comprenant un dispositif (26) selon l'une quelconque des revendications précédentes.

7. Chargeur selon la revendication 6, comprenant un relais (17) apte à connecter la seconde branche électrique (22) alternativement à une première borne (6) de connexion d'alimentation du chargeur (1), et à une seconde borne (7) de connexion d'alimentation du chargeur, distincte de la première borne, comprenant un second voltmètre (15) branché entre la borne de prise de terre (32), et la seconde borne (7), de manière à pouvoir être déconnecté par le relai et comprenant un troisième voltmètre (30) branché entre la borne de prise de terre (32), et la première borne (6) de manière à pouvoir être déconnecté par le relai.

8. Chargeur selon la revendication 7, comprenant en outre une unité de commande électronique (16) configurée, lors du branchement des bornes (6, 7) sur un réseau d'alimentation (3), pour faire basculer le relai (17) de manière à ce que la seconde branche électrique (22) soit connectée à celle des deux bornes (6, 7) pour laquelle la tension mesurée aux bornes de la seconde capacité (20) est la plus faible.

9. Chargeur selon la revendication 8, dans lequel l'unité de commande électronique (16) est configurée pour interdire le rechargement d'une batterie suite à une tentative de connexion à un réseau d'alimentation (3), si la tension mesurée aux bornes de la résistance (13) reste supérieure à une tension seuil après l'actionnement du relai (17).

10. Chargeur selon l'une quelconque des revendications 6 à 9, comportant une unité de commande électronique (16) configurée pour interdire le rechargement d'une batterie si une résistance de terre (24) calculée à partir des indications de l'ampèremètre (9) et du premier voltmètre (14) est supérieure ou égale à une résistance seuil.

## Patentansprüche

1. Vorrichtung (26) zur Messung eines Widerstandes (24) eines Masseanschlusses einer Anlage, umfassend:
- eine Stromquelle (8) und ein Amperemeter (9), die auf einem ersten elektrischen Zweig (21) angeordnet sind, der dazu vorgesehen ist, eine Phase (5) eines Versorgungsnetzes (3) mit dem Masseanschluss (19) der Anlage zu verbinden,
- einen zweiten elektrischen Zweig (22), der dazu vorgesehen ist, einen Nullleiter (4) des Versorgungsnetzes (3) mit dem Masseanschluss (19) der Anlage zu verbinden, umfassend einen Widerstand (13), an dessen Klemmen ein Voltmeter (14) angeschlossen ist, und umfassend eine erste Kapazität (10) in Serie mit dem Widerstand,
**dadurch gekennzeichnet, dass** die Vorrichtung einen dritten elektrischen Zweig (23) umfasst, der dazu vorgesehen ist, den Nullleiter (4) des Netzes mit dem Masseanschluss (19) der Anlage zu verbinden, und auf dem dritten Zweig (23) parallel zu der ersten Kapazität (10) und dem ersten Widerstand (13) eine zweite Kapazität (20) mit einem größeren Wert als die erste Kapazität (10) umfasst.

2. Vorrichtung nach Anspruch 1, bei der eine Induktanz (11) in Serie mit dem Widerstand (13) und mit der ersten Kapazität (10) parallel zu der zweiten Kapazität (20) angeordnet ist.

3. Vorrichtung nach Anspruch 1, bei der die zweite Kapazität (20) mindestens fünfmal größer als die erste Kapazität (10), vorzugsweise mindestens zehnmal größer als die erste Kapazität ist.

4. Vorrichtung nach einem der vorhergehenden Ansprüche, bei der die zweite Kapazität (20) einen Wert zwischen 10 und 100 nF und vorzugsweise zwischen 20 und 300 nF hat.

5. Vorrichtung nach einem der Ansprüche 2 bis 4, bei der die Induktanz (11) einen Wert zwischen 1 und 10 mH hat.

6. Ladegerät (1) für eine Kraftfahrzeugbatterie, umfassend eine Vorrichtung (26) nach einem der vorhergehenden Ansprüche.

7. Ladegerät nach Anspruch 6, umfassend ein Relais (17), das geeignet ist, den zweiten elektrischen Zweig (22) alternativ an eine erste Anschlussklemme (6) zur Versorgung des Ladegeräts (1) und eine zweite Anschlussklemme (7) zur Versorgung des Ladegeräts, die sich von der ersten Klemme unterscheidet, anzuschließen, umfassend ein zweites Voltmeter (15), das zwischen der Massenanschlussklemme (32) und der zweiten Klemme (7) angeschlossen ist, um durch das Relais abgetrennt zu werden, und umfassend ein drittes Voltmeter (30), das zwischen der Masseanschlussklemme (32) und der ersten Klemme (6) angeschlossen ist, um durch das Relais abgetrennt zu werden.

8. Ladegerät nach Anspruch 7, ferner umfassend eine elektronische Steuereinheit (16), die derart konfiguriert ist, dass sie beim Anschluss der Klemmen (6, 7) an ein Versorgungsnetz (3) das Relais (17) kippt, so dass der zweite elektrische Zweig (22) an jene der beiden Klemmen (6, 7) angeschlossen wird, für die die an den Klemmen der zweiten Kapazität (20) gemessene Spannung am geringsten ist.

9. Ladegerät nach Anspruch 8, bei dem die elektronische Steuereinheit (16) derart konfiguriert ist, dass sie das Aufladen einer Batterie nach einem Anschlussversuch an ein Versorgungsnetz (3) untersagt, wenn die an den Klemmen des Widerstandes (13) gemessene Spannung größer als eine Schwellenspannung nach Betätigung des Relais (17) bleibt.

10. Ladegerät nach einem der Ansprüche 6 bis 9, umfassend eine elektronische Steuereinheit (16), die derart konfiguriert ist, dass sie das Aufladen einer Batterie untersagt, wenn ein Masseanschlusswiderstand (24), der auf Basis der Angaben des Amperemeters (9) und des ersten Voltmeters (14) berechnet wird, größer als oder gleich einem Schwellenwiderstand ist.

## Claims

1. Device (26) for measuring a ground resistance (24) of an apparatus including:
- a current source (8) and an ammeter (9) arranged on a first electrical branch (21), provided for connecting a phase (5) of a power supply network (3) with the ground (19) of the apparatus,
- a second electrical branch (22) provided for connecting a neutral wire (4) of the power supply network (3) with the ground (19) of the apparatus, comprising a resistor (13) at the terminals of which a voltmeter (14) is connected, and comprising a first capacitor (10) in series with the resistor,
**characterized in that** the device comprises a third electrical branch (23) provided for connecting the neutral wire (4) of the network with the ground (19) of the apparatus, and comprises on the third branch (23), in parallel with the first capacitor (10) and the first resistor (13), a second capacitor (20) of higher value than the first capacitor (10).

2. Device according to Claim 1, wherein an inductor (11) is placed in series with the resistor (13) and with the first capacitor (10), parallel to the second capacitor (20).

3. Device according to Claim 1, wherein the second capacitor (20) is at least five times greater than the first capacitor (10), and preferably at least ten times greater than the first capacitor.

4. Device according to any one of the preceding claims, wherein the second capacitor (20) has a value between 10 and 100 nF, and preferably between 20 and 300 nF.

5. Device according to any one of Claims 2 to 4, wherein the inductor (11) has a value between 1 and 10 mH.

6. Charger (1) for a motor vehicle battery, including a device (26) according to any one of the preceding claims.

7. Charger according to Claim 6, including a relay (17) capable of connecting the second electrical branch (22) alternately to a first connecting terminal (6) of the charger (1) power supply, and a second connecting terminal (7) of the charger power supply, distinct from the first terminal, including a second voltmeter (15) connected between the ground connection terminal (32) and the second terminal (7) so that it can be disconnected by the relay, and including a third voltmeter (30) connected between the ground connection terminal (32) and the first terminal (6) so that it can be disconnected by the relay.

8. Charger according to Claim 7, further including an electronic control unit (16) configured, when the terminals (6, 7) are connected onto a power supply network (3), for switching the relay (17) so that the second electrical branch (22) is connected to that of the two terminals (6, 7) for which the voltage measured at the terminals of the second capacitor (20) is the lowest.

9. Charger according to Claim 8, wherein the electronic control unit (16) is configured for preventing the charging of a battery following an attempt to connect to a power supply network (3), if the voltage measured at the terminals of the resistor (13) remains higher than a threshold voltage after activation of the relay (17).

10. Charger according to any one of Claims 6 to 9, comprising an electronic control unit (16) configured for preventing the charging of a battery if a ground resistance (24) calculated from the readings of the ammeter (9) and the first voltmeter (14) is greater than or equal to a threshold resistance.
